# EUROPÄISCHE PATENTSCHRIFT

(11) **EP 0 968 637 B1**
(45) Veröffentlichungstag und Bekanntmachung des Hinweises auf die Patenterteilung: **18.09.2002**
(21) Anmeldenummer: 98925413.1
(22) Anmeldetag: 19.03.1998
(51) Int. Cl.: H05K 13/08

(54) **VERFAHREN ZUM VERMESSEN EINER EINRICHTUNG ZUR HERSTELLUNG VON ELEKTRISCHEN BAUGRUPPEN**
METHOD FOR GAUGING A DEVICE FOR PRODUCING ELECTRICAL COMPONENTS
PROCEDE DE MESURE D'UN EQUIPEMENT DE FABRICATION DE COMPOSANTS ELECTRIQUES

(30) Priorität: 19.03.1997 DE 19711476
(43) Veröffentlichungstag der Anmeldung: 05.01.2000
(73) Patentinhaber: SIEMENS AKTIENGESELLSCHAFT, 80333 München (DE)
(72) Erfinder: SCHIEBEL, Günter, D-81379 München (DE)
(86) Internationale Anmeldenummer: DE9800816
(87) Internationale Veröffentlichungsnummer: WO98042171

(56) Entgegenhaltungen:
- DE-A- 4 227 667
- US-A- 5 537 204

## Beschreibung

Die Erfindung bezieht sich auf ein Verfahren zum Vermessen einer Einrichtung zur Herstellung von elektrischen Baugruppen, insbesondere zum koordinatenmäßigen Bestücken von Leiterplatten mit Bauelementen, wobei durch die Einrichtung eine Testplatte von der Art einer Leiterplatte an definierten Aufsetzstellen mit scheibenartigen Nachbildungen der Bauelemente bestückt wird.

Bisher war es üblich, als Testplatte eine leiterplattenähnliche Glasplatte zu verwenden, die in ihren Eckbereichen Zentriermarken aufweist. Die mit einer doppelseitigen Klebefolie versehene Glasplatte wird in die z.B. als Bestückautomat ausgebildete Einrichtung eingelegt, worauf die Lage der Zentriermarken mittels einer ortsauflösenden Leiterplattenkamera des Bestückautomaten ermittelt wird. Sodann wird die Testplatte an relativ zu den Zentriermarken definierten Stellen mit Nachbildungen von Bauelementen bestückt.

In einem nachfolgenden Verfahrensschritt wird die bestückte Glasplatte in eine optische Meßmaschine eingelegt. Die Glasplättchen weisen definierte Markierungen auf, deren Lage relativ zu den Zentriermarken der Glasplatte in der Meßmaschine ermittelt wird. Aus den Lageabweichungen von der angestrebten Ideallage werden in den Koordinatenrichtungen und hinsichtlich der Drehlage Korrekturwerte ermittelt, die als Korrekturparameter in den Bestückautomaten eingegeben werden, der diese Abweichungen beim späteren Bestücken von Leiterplatten mit Bauelementen berücksichtigt.

Durch die US -A-5 537 204 ist ferner ein Kalibrierverfahren bekannt geworden, bei dem im Zentrum der Nachbildungen angeordnete Punktmarkierungen auf der Glasplatte mit Ringmarkierungen auf der Nachbildungen nachfolgend in einem optischen Comparator zu Ermittlung der X-Y-Abweichung verglichen werden. Ferner sind die Ränder der Nachbildungen als auf der Glasplatte als Quadrate nachgebildet sind und mit entsprechenden Markierungen der Nachbildungen im Comparator zur Ermittlung der Winkelabweichung verglichen werden.

Ferner ist durch die DE-A-42 27 667 eine Meßeinrichtung bekannt geworden, bei der sowohl auf der Glasplatte als auch auf den Nachbildungen unmittelbar einander benachbarte Strichmarkierungen angebracht sind, deren Abstand zueinander mittels eines Meßmikroskops ermittelt werden kann.

Ferner ist auf einem Symposium der Technischen Universität Dresden im August in Dresden, Deutschland 1995 durch Hr. Prof. Wohlrabe ein Meßsystem vorgestellt worden, bei dem die Vergleichsmarkierungen in enger Nachbarschaft, aber einander nicht überlappend angeordnet sind. Der Abstand ist so gering, daß beide Markierungen im Sichtbereich einer ortsauflösenden Sensors z.B. in Form einer CCD-Kamera gleichzeitig erscheinen können. Die Kamera kann mittels eines einfachen, wenig genauen Positioniersystems zu den einzelnen Doppelmarkierungen verschoben werden und dort die relative Lage der beiden Markierungen zueinander durch Bildauswertung ermitteln.

Die relative Lage der Referenzmarken zu den Strukturmerkmalen der Nachbildungen kann im Stillstand in einem Zuge ermittelt werden, ohne die Kamera verfahren zu müssen. Meßungenauigkeiten sind damit nur noch von der Qualität der Sensoroptik abhängig. Alle anderen Maschineneinflüsse sind damit völlig ausgeschaltet. Die CCD-Kamera ist mit einer Auswerteelektronik verbunden, in der die Relativlage der Strukturmerkmale zu den Referenzmarken errechnet wird.

Der Erfindung liegt die Aufgabe zugrunde, die Ermittlung der Korrekturparameter zu vereinfachen und zu beschleunigen. Diese Aufgabe wird durch die Erfindung nach Anspruch 1 gelöst.

Voraussetzung dabei ist, daß die lokalen Referenzmarken mit hoher Genauigkeit auf der Testplatte angebracht sind. Eine derartige Genauigkeit läßt sich z.B. mit Hilfe von photolitographischen Verfahren erreichen. Es ist möglich, bei den Nachbildungen auf eine Markierung zu verzichten und an deren Stelle z.B. die Außenkanten der Nachbildungen als definierte Strukturmerkmale zu verwenden. In solchen Fällen ist es vorteilhaft, anstelle der Glasplättchen entsprechende Keramikoder Metallteile zu verwenden, bei denen die Kanten leicht erkennbar sind.

Die Testplatte kann in einer Aufspannung sowohl mit den Nachbildungen bestückt als auch ohne zusätzliche Handhabung z.B. mit Hilfe einer Leiterplattenkamera vermessen werden, die fest mit einem Bestückkopf für die Bauelemente verbunden ist und die auch zum Zentrieren der Leiterplatten im Bestückautomaten verwendet werden kann.

Damit werden die beim Zentrieren der Meßplatte auftretenden Fehler eliminiert. Die Bestückung der Testplatte und das Verfahren der Leiterplattenkamera können mit Hilfe ein und desselben Steuergeräts durchgeführt werden.

Nachdem die Lagebestimmung bei allen aufgesetzten Nachbildungen durchgeführt worden ist, werden die systematischen Abweichungen in einer Auswerteeinrichtung berechnet. Diese Auswerteeinrichtung kann z.B. ein in das Steuergerät der Einrichtung eingebundenes Programmmodul sein, daß die berechneten Korrekturparameter z.B. nach Anspruch 2 als Festwerte ohne weiteres Zutun der Maschinensteuerung übermittelt.

Ein besonderer Vorteil eines solchen Verfahrens besteht darin, daß derartige Kalibriervorgänge nicht nur bei neu gefertigten Maschinen, sondern auch bei bereits im Einsatz befindlichen Maschinen von Zeit zu Zeit ohne besonderen Aufwand und ohne weitere Hilfsmittel z.B. bei turnusmäßigen Wartungsmaßnahmen durchgeführt werden können. Damit lassen sich z.B. verschleiß- oder alterungsbedingte Veränderungen der Positioniervorgänge mit geringem Aufwand überprüfen und korrigieren.

Durch die hohe Geschwindigkeit beim Vermessen der Markierungen ist es möglich, eine nach Anspruch 3 hohe Anzahl von Nachbildungen zu verwenden, so daß eine hinreichende Anzahl von Messungen zur statistischen Auswertung durchgeführt werden kann.

Im folgenden wird die Erfindung anhand eines in der Zeichnung dargestellten Ausführungsbeispieles näher erläutert.

Es zeigen:
- Figur 1: zeigt eine Draufsicht auf eine Testplatte mit darauf aufgesetzten Nachbildungen von Bauelementen,
- Figur 2: einen vergrößerten Ausschnitt aus der Testplatte nach Figur 1.

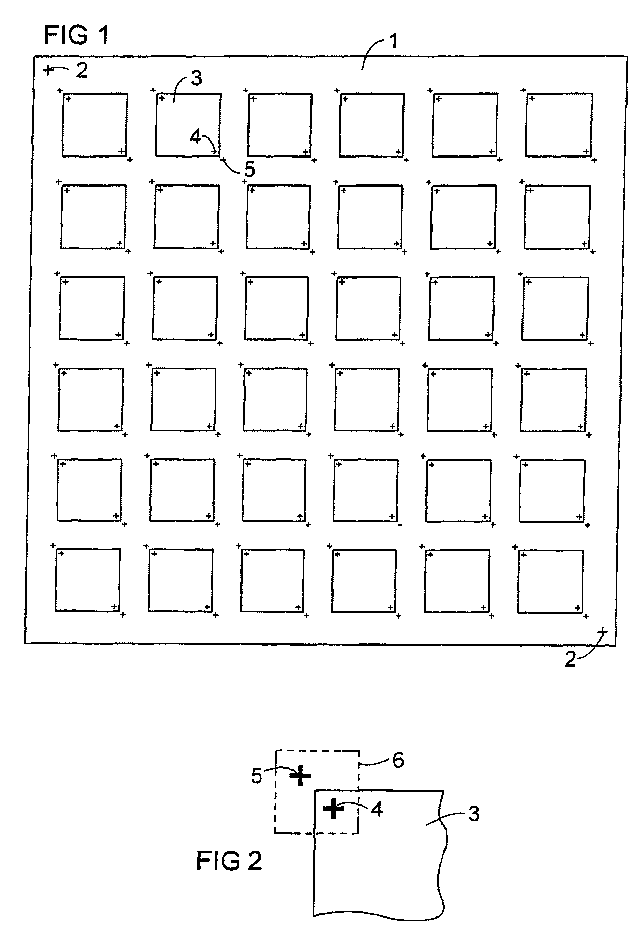

Nach den Figuren 1 und 2 weist eine aus einer Glasplatte bestehende Testplatte 1 in zwei einander diagonal gegenüberliegenden Ecken globale Zentriermarken 2 auf. Die Testplatte 1 ist in einem Bestückautomaten für elektrische Bauelemente an definierten Stellen mit Nachbildungen 3 solcher Bauelemente bestückt, wobei die Zentriermarken 2 der Lagezentrierung der Nachbildungen 3 im Bestückautomaten dienen.

Die Nachbildungen 3 bestehen aus kleinen Glasplättchen, die jeweils in zwei einander diagonal gegenüberliegenden Ecken Markierungen 4 in den Art von Fadenkreuzen aufweisen. Die Testplatte 1 ist an diesen Stellen im engen Abstand zu den Markierungen 4 mit lokalen Referenzmarken 5 versehen, die mit hoher Lagepräzision aufgebracht sind.

Die Markierungen 4 und die Referenzmarken 5 sind so eng benachbart, daß sie in ein Tastfeld 6 eines ortsauflösenden optischen Sensors passen, der an einem Bestückkopf für die Bauelemente befestigt ist. Dieser Bestückkopf ist derart verfahrbar, daß der Sensor über allen markierten Eckbereichen positionierbar ist.

Der ortsauflösende Sensor ist mit einer Auswerteelektronik verbunden, die in der Lage ist, die relative Lage der Markierungen 4 zu der jeweiligen Referenzmarke 5 zu ermitteln, ohne daß dabei der Sensor verfahren werden muß. Ein nicht dargestelltes Steuergerät der Bestückeinrichtung weist ein Auswertemodul auf, daß die einzelnen Abweichungen der Markierungen 4 von den Referenzmarken 5 zu Korrekturparametern für die Maschine verarbeitet. Diese Korrekturparameter werden automatisch vom Steuergerät übernommen.

## Patentansprüche

1. Verfahren zum Vermessen einer Einrichtung zur Herstellung von elektrischen Baugruppen, insbesondere zum koordinatenmäßigen Bestücken von Leiterplatten mit Bauelementen,
wobei mittels der Einrichtung eine Testplatte (1) von der Art einer Leiterplatte an definierten Aufsetzstellen mit scheibenartigen Nachbildungen (3) der Bauelemente bestückt wird,
wobei die Lage der Nachbildungen (3) relativ zu Referenzmarken (5) der Testplatte (1) anhand von lagedefinierten optischen Strukturmerkmalen (4) der Nachbildungen (3) durch einen optischen Sensor ermittelt wird, und
wobei aus Abweichungen der Lage der Strukturmerkmale (4) von ihrer Ideallage zumindest ein Korrekturparameter für ein Steuergerät der Einrichtung zur Herstellung der Baugruppen berechnet wird,
wobei die Referenzmarken (5) lokal an den Aufsetzstellen der Nachbildungen (3) angebracht werden und
wobei die Lage der Strukturmerkmale (4) relativ zu den ihnen jeweils zugeordneten lokalen Referenzmarken (5) ermittelt wird,
wobei der Abstand zwischen den Referenzmarken (5) und den optischen Strukturmerkmalen (4) der aufgesetzten Nachbildungen (3) geringer ist als die Weite eines Tastfelds (6) des ortsauflösenden Sensors,
wobei der Sensor sukzessive über die Referenzmarken (5) und Strukturmerkmale (4) verfahren wird,
wobei der Sensor von diesen Stellen Bilder aufnimmt, die jeweils sowohl die Referenzmarke (5) wie auch das Strukturmerkmal (z.B. 4) enthalten und
wobei die relative Lage des jeweiligen Strukturmerkmals (4) und der Referenzmarke (5) zueinander durch Auswertung der aufgenommenen Bilder ermittelt wird.
**dadurch gekennzeichnet,**
**daß** der Sensor Teil der Einrichtung zum Herstellen der Baugruppen ist und
**daß** das Auswerten der Bilder und das Berechnen des Korrekturparameters mittels einer optischen Auswerteeinrichtung der Einrichtung zur Herstellung der Baugruppen erfolgt.

2. Verfahren nach Anspruch 1,
**dadurch gekennzeichnet,**
**daß** der von der Auswerteeinrichtung ermittelte Korrekturparameter selbsttätig dem Steuergerät übermittelt und von diesem abgespeichert wird.

3. Verfahren nach Anspruch 2,
**dadurch gekennzeichnet,**
**daß** die Testplatte (1) in engem Abstand durchgehend mit einer Vielzahl von Nachbildungen (3) bestückt wird und
**daß** die Lage aller Nachbildungen (3) ermittelt wird.

## Claims

1. Method for gauging a device for producing electrical assemblies, particularly for fitting components to printed circuit boards on the basis of coordinates, the device being used to fit plate-like emulations (3) of the components to a test board (1) of the printed circuit board type at defined mounting points, the position of the emulations (3) relative to reference marks (5) on the test board (1) being determined by an optical sensor using positionally defined optical structural features (4) of the emulations (3), and divergences of the position of the structural features (4) from their ideal position being used to calculate at least one correction parameter for a controller for the device for producing the assemblies, the reference marks (5) being fitted locally to the mounting points of the emulations (3), and the position of the structural features (4) being determined relative to the local reference marks (5) assigned to each of them, the distance between the reference marks (5) and the optical structural features (4) of the mounted emulations (3) being shorter than the width of a scanning field (6) of the spatially resolving sensor, the sensor being moved gradually over the reference marks (5) and the structural features (4), the sensor taking pictures of these points, each of these pictures containing both the reference mark (5) and the structural feature (e.g. 4), and the relative position of the respective structural feature (4) and the reference mark (5) with respect to one another being determined by evaluating the pictures taken, **characterized in that** the sensor is part of the device for producing the assemblies, and **in that** the pictures are evaluated and the correction parameter is calculated using an optical evaluation device associated with the device for producing the assemblies.

2. Method according to Claim 1, **characterized in that** the correction parameter determined by the evaluation device is automatically transmitted to the controller and is stored by the latter.

3. Method according to Claim 2, **characterized in that** the test board (1) has a multiplicity of emulations (3) fitted to it throughout at a short distance apart, and **in that** the position of all the emulations (3) is determined.

## Revendications

1. Procédé destiné à mesurer un système de fabrication de modules électriques, notamment pour équiper, en suivant des coordonnées, des cartes à circuits imprimés avec des composants,
une carte de test (1), qui est du même genre qu'une carte à circuits imprimés, étant équipée, au moyen du système, à des positions de plantage définis, de reproductions (3) des composants ayant la forme de plaquettes,
la position des reproductions (3) par rapport aux repères de référence (5) de la carte de test (1) étant détectée par un capteur optique à l'aide de caractéristiques optiques structurelles (4) des reproductions (3), dont la position est définie, et
au moins un paramètre de correction pour un appareil de commande du système de fabrication des modules étant calculé à partir des déviations de la position des caractéristiques structurelles (4) par rapport à leur position idéale,
les repères de référence (5) étant apposés localement aux emplacements de plantage des reproductions (3) et
la position des caractéristiques structurelles (4) par rapport aux repères de référence locaux (5), qui leur correspondent, étant détectée,
la distance entre les repères de référence (5) et les caractéristiques optiques structurelles (4) des reproductions (3) apposées étant inférieure à la largeur d'un champ de balayage (6) du capteur à résolution locale,
le capteur étant déplacé successivement au dessus des repères de référence (5) et des caractéristiques structurelles (4),
le capteur enregistrant des images de ces endroits, lesquelles renferment non seulement le repère de référence (5), mais aussi la caractéristique structurelle (par exemple, 4) et
la position relative de la caractéristique structurelle respective (4) et du repère de référence (5) l'une par rapport à l'autre étant déterminée par analyse des images enregistrées,
**caractérisé par le fait**
**que** le capteur fait partie du système de fabrication des modules et
**que** l'analyse des images et le calcul des paramètres de correction sont effectués au moyen d'un dispositif optique d'évaluation du système de fabrication des modules.

2. Procédé selon la revendication 1
**caractérisé par le fait**
**que** le paramètre de correction déterminé par le dispositif d'évaluation est transmis automatiquement à l'appareil de commande et mémorisé par celui-ci.

3. Procédé selon la revendication 2
**caractérisé par le fait**
**que** la carte de test (1) est équipée, d'une façon continue et avec très peu d'écart, d'une pluralité de reproductions (3) et
**que** la position de toutes les reproductions (3) est détectée.
